# EUROPÄISCHE PATENTANMELDUNG

(11) **EP 2 203 035 A2**
(43) Veröffentlichungstag der Anmeldung: **30.06.2010**
(21) Anmeldenummer: 09177021.4
(22) Anmeldetag: 25.11.2009
(51) Int. Cl.: H05K 3/00

(54) **Automatisierte Werkzeugmaschine und Verfahren zum Einbringen von Referenzbohrungen in Leiterplatten**

(30) Priorität: 22.12.2008 DE 102008064166
(71) Anmelder: Schmoll Maschinen Gmbh, 63322 Rödermark-Oberroden (DE)
(72) Erfinder: Kunz, Stephan, 61476 Kronberg (DE); Vos, Markus Dr., 55218, Ingelheim (DE)
(74) Vertreter: KEIL & SCHAAFHAUSEN Patentanwälte

(57) **Zusammenfassung**

Die Erfindung betrifft eine automatisierte Werkzeugmaschine mit einem Werkstückträger (1) zur Aufnahme einer Leiterplatte (3, 3'), wenigstens einer Bohrstation (8) zur Bearbeitung von Leiterplatten sowie einer Einrichtung zum aufeinanderfolgenden Aufbringen einzelner Leiterplatten (3, 3') auf den Werkstückträger (1) und zum Entfernen von Leiterplatten von dem Werkstückträger. Weiter betrifft die Erfindung ein Verfahren zum Einbringen von Referenzbohrungen in Leiterplatten (3, 3').

## Beschreibung

Die Erfindung betrifft eine automatisierte Werkzeugmaschine mit einem Werkstückträger zur Aufnahme einer Leiterplatte, wenigstens einer Bohrstation zur Bearbeitung von Leiterplatten sowie einer Einrichtung zum aufeinanderfolgenden Aufbringen einzelner Leiterplatten auf den Werkstückträger und zum Entfernen von Leiterplatten von dem Werkstückträger. Weiter betrifft die Erfindung ein Verfahren zum Einbringen von Referenzbohrungen in Leiterplatten.

Die Bearbeitung von Leiterplatten (sog. Panels) erfolgt manuell oder meist automatisiert in Werkzeugmaschinen, die die genaue Position und/oder die Ausrichtung der Leiterplatte mit hoher Genauigkeit erfassen müssen, um eine präzise Bearbeitung erreichen zu können. Hierzu ist es bekannt, dass Leiterplatten vor der eigentlichen Bearbeitung mit Referenzbohrungen versehen werden, die in nachfolgenden Bearbeitungsschritten von den Werkzeugmaschinen beispielsweise mit einer CCD-Kamera erfasst werden und/oder als Referenz genommen werden, um dann beispielsweise Bohrungen in die Leiterplatten einzubringen.

Die Qualität derartiger Referenzbohrungen muss bei der optischen Erfassung der Referenzbohrungen besonders hoch sein. Insbesondere kann ein Grat, der häufig beim Eintritt eines Bohrers in die Leiterplatten entsteht, die exakte optische Erfassung der Referenzbohrung erheblich erschweren. Die Genauigkeit der nachfolgenden Bearbeitungsschritte sinkt damit bei einer schlechten Qualität der Referenzbohrung. Bei der mechanischen Indizierung z.B. über Stifte kann der Grat ebenfalls die Aufnahmegenauigkeit negativ beeinflussen.

Wenn bei der Bearbeitung von Werkstücken eine Deckschicht (Entry) und/oder eine Unterlageschicht (Backup) vorgesehen werden, bevor in die Werkstücke gebohrt wird, werden diese Deckschicht (Entry) bzw. die Unterlageschicht (Backup) nach der Bearbeitung des Werkstücks verworfen. Bei der Bearbeitung von Leiterplatten (Panels) ist insbesondere vor dem Einbringen von Referenzbohrungen ein Abdecken der Leiterplatte mit einer Deckschicht nachteilig, da dies die Erfassung der Position und/oder der Ausrichtung der Leiterplatte auf einem Werkstückträger mittels einer CCD-Kamera oder einem Röntgengerät erschwert oder gar verhindert.

Aufgabe der vorliegenden Erfindung ist es demgegenüber, eine Werkzeugmaschine sowie ein Verfahren der eingangs genannten Art bereitzustellen, die das Einbringen von Referenzbohrungen kostengünstig, in hoher Qualität und mit kurzen Taktzeiten ermöglicht.

Diese Aufgabe wird mit einer automatisierten Werkzeugmaschine der eingangs genannten Art dadurch gelöst, dass die Einrichtung zum aufeinanderfolgenden Aufbringen einzelner Leiterplatten (Panels) auf dem Werkstückträger und zur Entfernung von Leiterplatten von dem Werkstückträger derart ausgebildet und/oder eingerichtet ist, dass die Leiterplatten definiert versetzt zu der jeweils vorhergehenden Leiterplatte auf dem Werkstückträger aufgebracht werden. Darüber hinaus ist eine zweite Einrichtung zum Aufbringen einer Deckschicht (Entry) auf die jeweils auf dem Werkstückträger positionierte Leiterplatte und zum Entfernen der Deckschicht von der Leiterplatte vorgesehen. Eine Steuerung kann den Antrieb des Werkstückträgers, die Bohrstation, die erste Einrichtung und die zweite Einrichtung betätigen. Mit anderen Worten kombiniert die erfindungsgemäße Werkzeugmaschine eine sog. Panelshift-Funktion, durch welche nacheinander bearbeitete Leiterplatten (Panels) nicht auf der gleichen Position, sondern versetzt zueinander auf dem Werkstückträger aufgebracht werden, sowie das Vorsehen einer Deckschicht auf den Leiterplatten. Die Verwendung der Deckschicht sorgt dafür, dass Referenzbohrungen mit sehr hoher Qualität und insbesondere ohne einen Grat an der Eintrittsstelle des Bohrers in die Leiterplatten eingebracht werden können.

Die Deckschicht kann dabei erfindungsgemäß für die Bearbeitung vieler aufeinanderfolgender Leiterplatten verwendet werden und muss nicht nach jeder bearbeiteten Leiterplatte ausgewechselt und verworfen werden, da die Leiterplatten in einem definiert versetzten Raster auf dem Werkstückträger aufgebracht werden. Folglich werden auch die Bohrungen an zueinander versetzten Positionen des Werkstückträgers und der Deckschicht eingebracht. Da die Leiterplatten ohne die Deckschicht auf den Werkstückträger aufgesetzt werden, kann die genaue Position und Ausrichtung der Leiterplatten jeweils erfasst werden, bevor die Deckschicht aufgebracht wird. Dies ist bei der Erfassung der Position und Ausrichtung der Leiterplatte mittels einer CCD-Kamera oder dgl. erforderlich. Beim Einsatz von Röntgenverfahren zur Positionserfassung der Leiterplatten kann das Deckmaterial auch so gewählt sein, dass dieses bereits vor der Positionserfassung auf die Leiterplatte aufgebracht wird.

Nach einer ersten Ausführungsform der Erfindung weist die zweite Einrichtung einen insbesondere mit mehreren Saugern versehenen Greifer oder einen Halter zum Abheben und Absenken der Deckschicht auf dem Werkstückträger auf. Das Abheben und Absenken der Deckschicht erfolgt somit durch eine Einrichtung, die von dem Werkstückträger und dessen Antrieb unabhängig sein kann und beispielsweise im Hinterraum bzw. Innenraum der Maschine vorgesehen ist. Diese Einrichtung kann vor jedem Bohrzyklus die Deckschicht auf die jeweilige Leiterplatte ablegen und danach wieder aufnehmen. Durch das Verlegen der Leiterplatten beim Panelshift wird somit jedes Loch an einer neuen Position gebohrt.

In Weiterbildung dieses Erfindungsgedankens ist der Werkstückträger zum Abheben und Absenken der Deckschicht unter dem Greifer verfahrbar. Der Greifer kann somit als eine vergleichsweise einfache Einrichtung ausgeführt sein, die lediglich mittels Saugern oder dgl. die Deckschicht festhalten und definiert anheben oder absenken muss. Hierbei wird der ohnehin vorgesehene Antrieb des Werkstückträgers genutzt, der es ermöglicht, dass der Werkstückträger zusammen mit der darauf aufgelegten Leiterplatte unter den Greifer fährt, wenn die Deckschicht aufgelegt oder abgenommen werden soll. Mit anderen Worten wird der Werkstückträger (Maschinentisch) jeweils aus der Bearbeitungs- oder Panelwechselposition unter das Entry-System gefahren. Dies kann bis zu 5 sec. beanspruchen.

Alternativ hierzu ist es auch möglich, dass dem Greifer oder Halter ein Antrieb zugeordnet ist, wobei der Greifer oder Halter zum Abheben und Absenken der Deckschicht über den Werkstückträger verfahrbar ist. Die Deckschicht wird hierbei nicht nur aufgelegt und abgenommen, sondern auch in die richtige Position über dem Werkstückträger gebracht. Dies ist durch den zusätzlichen Antrieb des Greifers oder Halters zwar mit einem erhöhten Aufwand verbunden, kann jedoch zu einer Senkung der Taktzeiten für einen Bohrzyklus führen. In diesem Fall ist die Deckschicht vorzugsweise in einem Rahmen oder dgl. Halter eingespannt.

Nach einer zweiten Ausführungsform der Erfindung ist die zweite Einrichtung als ein Träger für die Deckschicht (Entry) ausgebildet, wobei der Träger der Bohrstation derart zugeordnet ist, dass die Deckschicht gemeinsam mit der Bohrstation relativ zu dem Werkstückträger und/oder einer auf diesem angeordneten Leiterplatte positionierbar ist. Dieser Ausführungsform liegt der Gedanke zugrunde, dass die Bohrstation für die Bearbeitung der Leiterplatte relativ zu dem Werkstückträger bzw. der Leiterplatte ausgerichtet werden muss. Wenn die Deckschicht einem Träger der Bohrstation zugeordnet ist, wird die Deckschicht automatisch gemeinsam mit der Bohrstation in die richtige Lage relativ zu der Leiterplatte bzw. dem Werkstückträger gebracht.

Hierbei hat es sich als vorteilhaft erwiesen, wenn die Deckschicht im Wesentlichen bandförmig ist, wobei die zweite Einrichtung Rollen zum definierten Auf- und Abrollen der bandförmigen Deckschicht aufweist. Die Rollen mit der Deckschicht sind dabei so an der Bohrstation angeordnet, dass bei jedem Bohrvorgang die Deckschicht durchbohrt wird. Die Rollen sorgen dafür, dass die bandförmige Deckschicht nach jedem Bohrvorgang taktweise weiter bewegt wird, so dass jede Bohrung in einer neuen Position der Deckschicht eingebracht wird. Die Rollen können gleichzeitig zum Anpressen der Deckschicht an die Leiterplatte bzw. dem Werkstück dienen. Für einen Bohrerwechsel können die Rollen wegklappbar oder wegschwenkbar der Bohrstation zugeordnet sein.

Alternativ hierzu kann die Deckschicht als eine relativ zu der Bohrstation bewegbare Scheibe ausgebildet sein. Diese Scheibe kann auf einem beispielsweise neben der Bohrstation positionierten Träger so vorgesehen sein, dass die Deckschicht gemeinsam mit der Bohrstation relativ zu der Leiterplatte bzw. dem Werkstückträger bewegbar ist. Die scheibenartige Deckschicht kann dabei ebenfalls taktweise gedreht und/oder relativ zu der Bohrstation bewegt werden, damit die Deckschicht (Entry) bei jedem Bohrvorgang an einer neuen Position durchbohrt wird.

Es wird bevorzugt, wenn die Deckschicht eine Platte oder Folie mit einer Dicke von etwa 0,1 mm bis etwa 1 mm, insbesondere etwa 0,2 mm bis etwa 0,5 mm, ist. Das Material der Deckschicht (Entry) kann Aluminium oder Kunststoff, beispielsweise Melamin, sein. Die Deckschicht muss dabei ausreichend steif sein, um selbst im mehrfach durchbohrten Zustand sicher auf den Werkstückträger bzw. eine Leiterplatte abgelegt und von diesen abgenommen werden zu können. Andererseits muss das Material der Deckschicht auch ein gutes Eindringen des Bohrers ermöglichen und eine Gratbildung in der Leiterplatte verhindern.

Die Qualität der in die Leiterplatten einzubringenden Bohrungen kann dadurch weiter verbessert werden, dass nicht nur auf der der Bohrstation zugewandten Seite eine Deckschicht vorgesehen ist, sondern auch zwischen dem Werkstückträger und der Leiterplatte eine Unterlageschicht (Backup) vorgesehen ist. Diese Unterlageschicht ist vorzugsweise lösbar auf dem Werkstückträger fixiert, beispielsweise mittels Saugern, so dass die nacheinander zu bearbeitenden Leiterplatten versetzt zueinander auf der plattenartigen Unterlageschicht aufgelegt werden. Hierdurch wird erreicht, dass nicht nur in der Deckschicht (Entry), sondern auch in der Unterlageschicht (Backup) jedes Loch an einer neuen Position gebohrt wird, wodurch sich ein Ausfransen des Bohrlochs im Bereich des Bohreraustritts vermeiden lässt.

Um diesen Versatz der Leiterplatten zu ermöglichen, ist die Fläche zumindest der Unterlageschicht größer als die Fläche der jeweils zu bearbeitenden Leiterplatte. Wenn die Unterlageschicht deutlich größer als die zu bearbeitenden Leiterplatten ist, können mit der Panelshift-Funktion sehr viele Leiterplatten bearbeitet werden, bevor die Unterlageschicht sowie ggf. die Deckschicht ausgewechselt werden muss.

Vor dem Einbringen der Referenzbohrungen in eine Leiterplatte ist es notwendig, die Position und Ausrichtung der Leiterplatte selbst genau zu erfassen. Hierzu ist der Steuerung der erfindungsgemäßen Werkzeugmaschine eine Erfassungseinrichtung zugeordnet, beispielsweise eine CCD-Kamera oder ein Röntgengerät, so dass die Position und/oder Ausrichtung der Leiterplatte auf dem Werkstückträger bzw. auf der Unterlageschicht genau bestimmbar ist.

Die der Erfindung zugrunde liegende Aufgabe wird weiter durch ein Verfahren zum Einbringen von Referenzbohrungen in Leiterplatten gelöst, welches folgende Schritte aufweist:
a) Auflegen einer zu bearbeitenden Leiterplatte auf einer definierten Position auf einer Unterlageschicht, die auf einem Werkstückträger lösbar fixiert ist,
b) Auflegen und/oder Andrücken einer Deckschicht auf zumindest einen Bereich der Leiterplatte,
c) Bearbeiten der Leiterplatte durch Einbringen wenigstens einer Bohrung in die Leiterplatte,
d) Abnehmen der Deckschicht von der Leiterplatte und
e) Entfernen der bearbeiteten Leiterplatte,
f) wiederholen der Schritte a) bis e) ohne Austausch der Unterlageschicht und der Deckschicht,
wobei vor dem Schritt c) die Position und/oder die Ausrichtung der Leiterplatte erfasst wird, und wobei die Unterlageschicht, die zu bearbeitende Leiterplatte und die Deckschicht vor dem Schritt d) so relativ zueinander ausgerichtet werden, dass die bei der aufeinanderfolgenden Bearbeitung mehrerer Leiterplatten in der Unterlageschicht und in der Deckschicht entstehenden Bohrlöcher in einem definierten Raster zueinander versetzt sind. Dieses Verfahren kann insbesondere auf einer automatisierten Werkzeugmaschine der oben genannten Art durchgeführt werden.

Wenn die Position und/oder die Ausrichtung der Leiterplatte mittels optischer Verfahren, beispielsweise durch Erfassung von Passermerken mit einer CCD-Kamera, erfasst wird, muss dies vor dem Auflegen und/oder Andrücken der Deckschicht auf die Leiterplatte erfolgen. Wenn dagegen die Position und/oder die Ausrichtung der Leiterplatte durch eine Röntgenaufnahme erfasst wird, kann dies auch nach dem Aufbringen der Deckschicht erfolgen. In Abhängigkeit der Dicke der Leiterplatte sowie des Materials der Deckschicht kann es jedoch auch bei dem Vermessen der Panels mittels Röntgen vorteilhaft sein, die Position und/oder die Ausrichtung der Leiterplatte zu erfassen, bevor die Deckschicht aufgebracht wird.

Der definierte Versatz der in der Unterlageschicht und in der Deckschicht entstehenden Bohrlöcher wird erfindungsgemäß dadurch erzeugt, dass bei mehreren, insbesondere baugleichen, nacheinander zu bearbeitenden Leiterplatten die Bohrungen an zumindest im Wesentlichen gleicher Position auf den Leiterplatten erzeugt werden, wobei die nacheinander zu bearbeitenden Leiterplatten jeweils zueinander versetzt auf die Unterlageschicht bzw. den Werkstückträger aufgelegt werden (Panelshift-Funktion).

In der Praxis hat es sich als besonders vorteilhaft erwiesen, wenn nach einer Serie im Wesentlichen baugleicher Leiterplatten, die in der erfindungsgemäßen Werkzeugmaschine bzw. mit dem erfindungsgemäßen Verfahren bearbeitet werden, die Unterlageschicht und/oder Deckschicht ausgewechselt werden. Dies sollte bei einer sehr großen Anzahl zu bearbeitender Leiterplatten auch nach einer vorzugsweise voreinstellbaren Anzahl von Bohrlöchern erfolgen, damit sichergestellt bleibt, dass jedes Loch an einer neuen Position in der Unterlageschicht (Backup) und der Deckschicht (Entry) gebohrt wird. Hierzu wird die Deckschicht vor dem Einbringen eines neuen Bohrlochs relativ zu einer Bohrstation oder dgl. Einrichtung zum Einbringen von Bohrlöchern definiert in einer zu der Bohrrichtung senkrechten Ebene bewegt.

Die Erfindung wird nachfolgend anhand von Ausführungsbeispielen und unter Bezugnahme auf die Zeichnung näher erläutert. Es zeigen schematisch:
- Figur 1: in Schnittansicht eine Leiterplatte (Panel) während des Einbringens einer Referenzbohrung,

- Figur 2: in Draufsicht die Komponenten einer Werkzeugmaschine nach einer ersten Ausführungsform der Erfindung,
- Figur 3: in Draufsicht die Komponenten einer Werkzeugmaschine nach einer zweiten Ausführungsform der Erfindung,
- Figur 4: eine Bohrstation mit zugeordneter Deckschicht einer Werkzeugmaschine nach einer dritten Ausführungsform der Erfindung,
- Figur 5: eine Bohrstation mit zugeordneter Deckschicht einer Werkzeugmaschine nach einer vierten Ausführungsform der Erfindung und
- Figur 6: in Seitenansicht eine Werkzeugmaschine nach Figur 2.

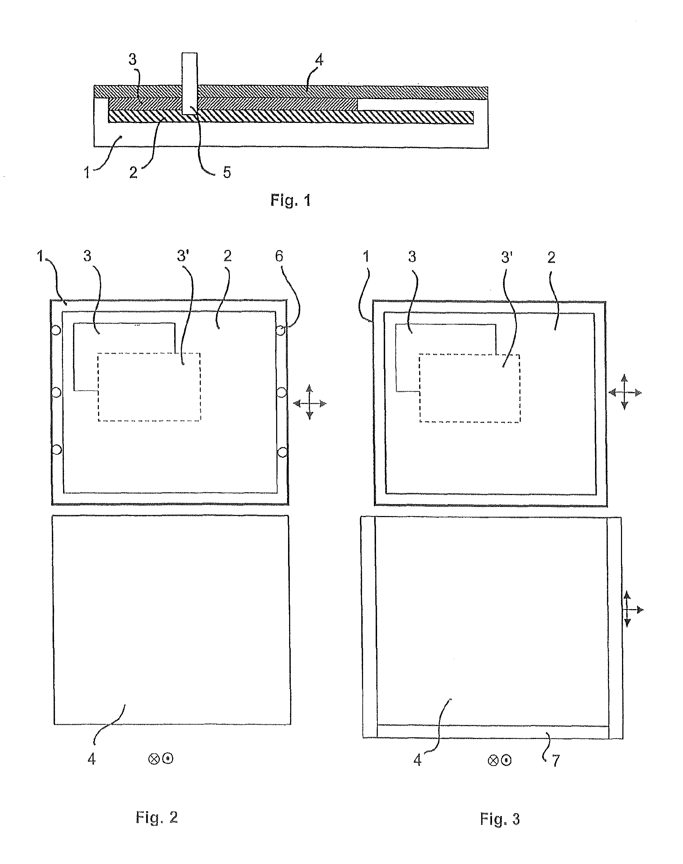

In Figur 1 ist ein Werkstückträger 1 einer Werkzeugmaschine gezeigt, auf welchem über nicht dargestellte Sauger oder dgl. eine Unterlageschicht (Backup) 2 lösbar fixiert ist. Auf der Unterlageschicht 2 ist eine Leiterplatte (Panel) 3 an einer definierten Position aufgelegt. Die Leiterplatte 3 ist in der dargestellten Abbildung als eine Schicht dargestellt, sie kann jedoch aus mehreren Schichten bestehen. Über der Leiterplatte 3 ist eine Deckschicht (Entry) 4 aufgebracht, die als eine dünne Folie aus Aluminium oder Kunststoff ausgebildet sein kann. Über einen Bohrer 5 einer in Figur 1 nicht dargestellten Bohrstation wird eine Referenzbohrung in die Leiterplatte 3 eingebracht. Der Bohrer 5 durchdringt dabei zunächst die Deckschicht 4, dann die Leiterplatte 3 und dringt schließlich in die Unterlageschicht 2 ein. Die Deckschicht 4 und die Unterlageschicht 2 verhindern dabei, dass während des Bohrvorganges Grate oder Ausfransungen im Eintritts- oder Austrittsbereich des Bohrers 5 durch die Leiterplatte 3 entstehen.

Gegenüber einem herkömmlichen Maschinentisch ist der in Figur 1 gezeigte Werkstückträger 1 verändert, indem eine Vertiefung für die Unterlageschicht 2 und die Leiterplatte 3 ausgebildet ist. Hierdurch kann auch bei Paneldicken ≥1,2 mm das Entry-Material ggf. über ein separates (Vakuum-)Spannsystem befestigt werden. Bei Paneldicken ≤ 1,2 mm kann das Entry mit dem Backup zusammen im Randbereich des Werkstückträgers 1 gehalten werden.

In Figur 2 ist eine erste Ausführungsform der Werkzeugmaschine dargestellt. Der Werkstückträger 1 ist dabei, wie durch die Pfeile angedeutet, in der Zeichnungsebene bewegbar. Die Unterlageschicht 2 ist auf dem Werkstückträger 1 fixiert und wird gemeinsam mit diesem bewegt. Über eine nicht dargestellte Einrichtung wird bei jedem Bohrzyklus eine Leiterplatte 3 auf die Unterlageschicht 2 aufgelegt. Wie durch die gestrichelten Linien angedeutet, wird bei der aufeinanderfolgenden Bearbeitung mehrerer Leiterplatten 3, 3' jede Leiterplatte zu der vorherigen versetzt auf der Unterlageschicht 2 und dem Werkstückträger 1 positioniert. Im Hinterraum der Werkzeugmaschine ist eine ebenfalls nicht näher dargestellte Einrichtung vorgesehen, mit welcher die Deckschicht 4, wie durch die Pfeile angedeutet, angehoben und abgesenkt werden kann.

Nach dem Auflegen einer Leiterplatte 3 auf die Unterlageschicht 2 wird der Werkstückträger 1 gemeinsam mit der Unterlageschicht 2 und der Leiterplatte 3 unter die Deckschicht 4 verfahren, so dass die Deckschicht 4 auf den Werkstückträger 1 abgesenkt werden kann. Durch schematisch angedeutete Sauger 6 kann die Deckschicht 4 auf dem Werkstückträger 1 lösbar fixiert werden. Der Werkstückträger 1 fährt dann gemeinsam mit der Unterlageschicht 2, der Leiterplatte 3 und der Deckschicht 4 in eine Position zurück, die das Einbringen von Referenzbohrungen durch eine nicht näher dargestellte Bohrstation ermöglicht. Anschließend wird der Werkstückträger 1 wieder unter die Einrichtung zum Ablegen und Aufnehmen der Deckschicht 4 verfahren, so dass die Deckschicht abgenommen werden kann. Die Deckschicht wird dabei jeweils auf die gleiche Position des Werkstückträgers 1 aufgelegt, so dass durch den Versatz der Leiterplatten 3, 3' die Bohrungen stets an unterschiedlichen Positionen der Unterlageschicht 2 und der Deckschicht 4 eingebracht werden.

Der Produktionsablauf der in Figur 2 gezeigten Maschine beim Einbringen von Referenzbohrungen sieht folgende Schritte vor:
1. Entry (Deckschicht 4) hängt am Greifer.
2. Panel (Leiterplatte 3) kommt auf den Maschinentisch (Werkstückträger 1) und wird mit dem Backup (Unterlageschicht 2) zusammen über das Vakuumspannsystem gehalten.
3. Panel wird mittels Röntgen vermessen.
4. Maschinentisch fährt nach hinten unter das Entry- System.
5. Greifer legt Entry ab (≤ 5sec.).
6. Entry wird mit dem Vakuumspansystem gehalten.
7. Panel wird gebohrt.
8. Maschinentisch fährt unter das Entry- System.
9. Spannsystem wird kurzzeitig geöffnet, Entry wird durch den Geifer abgehoben (≤ 5sec.).
10. Maschinentisch fährt in die Panelwechselposition, das fertige Panel wird entnommen, das nächste Panel um einen "Shift" versetzt aufgelegt.
Die Zyklen Rüsten von Backup und Entry werden per Software unterstützt.

Die in Figur 3 dargestellte Werkzeugmaschine unterscheidet sich von der in Figur 2 gezeigten Ausführungsform darin, dass die wiederum nicht näher dargestellte Einrichtung zum Ablegen und Aufnehmen der Deckschicht 4 mit einem eigenen Antrieb versehen ist, so dass die beispielsweise in einem schematisch angedeuteten Rahmen 7 eingespannte Deckschicht 4 wie durch die Pfeile angedeutet, über den Werkstückträger 1 verfahren und dort abgesenkt oder angehoben werden kann. Der Werkstückträger 1 muss somit nicht jeweils unter die Einrichtung zum Auflegen oder Abnehmen der Deckschicht verfahren werden.

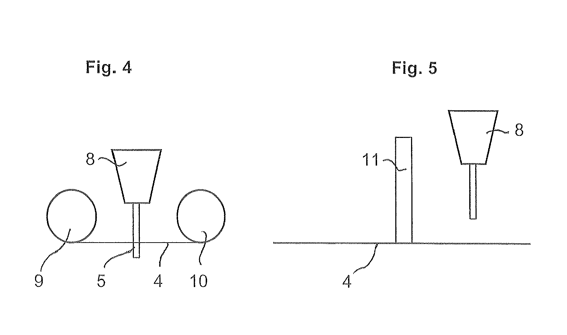

Bei der Ausführungsform nach Figur 4 ist die Deckschicht 4 einer schematisch dargestellten Bohrstation 8 zugeordnet. Hierzu sind zwei Rollen 9 und 10 vorgesehen, auf denen das in dieser Ausführungsform bandartige Material der Deckschicht 4 auf- bzw. abgerollt wird. Die Rollen 9 und 10 können dabei gemeinsam mit der Bohrstation 8 relativ zu der Leiterplatte 3 bzw. dem Werkstückträger 1 ausgerichtet werden. Während des Einbringens einer Bohrung durchdringt der Bohrer 5 der Bohrstation 8 die Deckschicht 4, die auf der Leiterplatte 3 aufliegt. Nach jedem Bohrvorgang wird die Deckschicht 4 durch die Rollen 9 und 10 taktweise weiter bewegt, so dass jede Bohrung in eine neue Position der Deckschicht 4 eingebracht wird.

Bei der Ausführungsform nach Figur 5 sind statt der Rollen 9 und 10 mit der bandförmigen Deckschicht 4 eine scheibenartige Deckschicht 4 und ein Träger 11 vorgesehen, die ebenfalls der Bohrstation 8 zugeordnet sind. Die scheibenartige Deckschicht 4 ist dabei durch den Träger 11 drehbar sowie ggf. relativ zu der Bohrstation 8 verschiebbar angeordnet, wodurch ebenfalls erreicht wird, dass jede Bohrung in einer neuen Position der Deckschicht 4 eingebracht wird. Wie oben unter Bezugnahme auf Figur 4 erläutert, soll der Träger 11 der Bohrstation 8 so zugeordnet sein, dass diese gemeinsam relativ zu dem Werkstückträger 1 und der Leiterplatte 3 ausgerichtet werden.

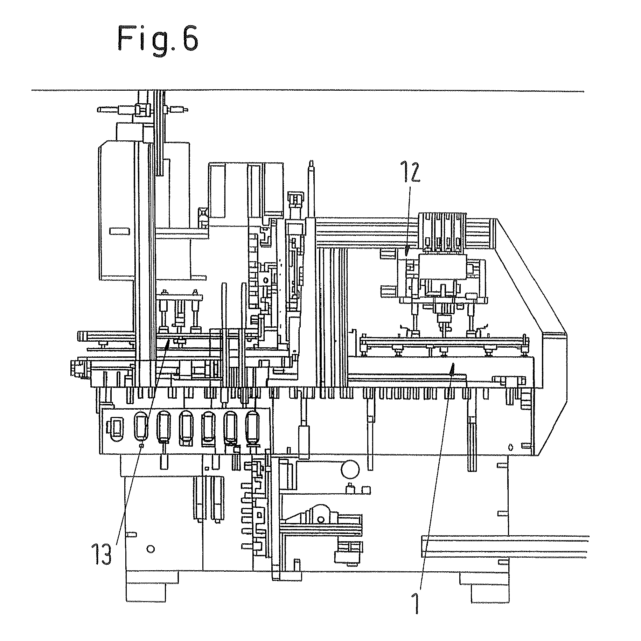

Die Ansicht der Figur 6 zeigt eine erfindungsgemäße Werkzeugmaschine mit einem Be- und Entlader 12 für die Panels 3 sowie einem Greifersystem 13 für das Entry-Material 4, das im Hinter- bzw. Innenraum der Maschine angeordnet ist.

### Bezugszeichenliste:

- 1: Werkstückträger
- 2: Unterlageschicht (Backup)
- 3, 3': Leiterplatte (Panel)
- 4: Deckschicht (Entry)
- 5: Bohrer
- 6: Sauger
- 7: Rahmen
- 8: Bohrstation
- 9, 10: Rollen
- 11: Träger
- 12: Be- und Entlader
- 13: Greifersystem

## Patentansprüche

1. Automatisierte Werkzeugmaschine mit
einem Werkstückträger (1) zur Aufnahme einer Leiterplatte (3, 3'), wobei dem Werkstückträger (1) ein Antrieb zur Bewegung des Werkstückträgers zumindest in einer horizontalen Ebene zugeordnet ist,
wenigstens einer Bohrstation (8) zur Bearbeitung von Leiterplatten (3, 3'), wobei der Werkstückträger (1) und die wenigstens eine Bohrstation (8) relativ zueinander angetrieben bewegbar sind,
einer ersten Einrichtung (12) zum aufeinanderfolgenden Aufbringen einzelner Leiterplatten (3, 3') auf den Werkstückträger (1) und zum Entfernen von Leiterplatten (3, 3') von dem Werkstückträger, wobei diese erste Einrichtung derart ausgebildet und/oder eingerichtet ist, dass die Leiterplatten (3, 3') definiert versetzt zu der jeweils vorhergehenden Leiterplatte (3) auf den Werkstückträger (1) aufgebracht werden,
einer zweiten Einrichtung (13) zum wiederholten Aufbringen einer Deckschicht (4) auf die jeweils auf dem Werkstückträger (1) positionierte Leiterplatte (3, 3') und zum Entfernen der Deckschicht (4) von der Leiterplatte und mit
einer Steuerung zur Betätigung des Antriebs des Werkstückträgers (1), der Bohrstation (8), der ersten Einrichtung und der zweiten Einrichtung.

2. Werkzeugmaschine nach Anspruch 1, **dadurch gekennzeichnet, dass** die zweite Einrichtung einen insbesondere mit mehreren Saugern versehenen Greifer oder Halter (7) zum Abheben und Absenken der Deckschicht (4) von dem bzw. auf den Werkstückträger (1) aufweist.

3. Werkzeugmaschine nach Anspruch 2, **dadurch gekennzeichnet, dass** der Werkstückträger (1) zum Abheben und Absenken der Deckschicht (4) unter den Greifer verfahrbar ist.

4. Werkzeugmaschine nach Anspruch 2 oder 3, **dadurch gekennzeichnet, dass** dem Greifer oder Halter (7) ein Antrieb zugeordnet ist, wobei der Greifer oder Halter (7) zum Abheben und Absenken der Deckschicht (4) über den Werkstückträger (1) verfahrbar ist.

5. Werkzeugmaschine nach Anspruch 1, **dadurch gekennzeichnet, dass** die zweite Einrichtung als ein Träger (9, 10, 11) für die Deckschicht (4) ausgebildet ist, wobei der Träger (9, 10, 11) der Bohrstation (8) derart zugeordnet ist, dass die Deckschicht (4) gemeinsam mit der Bohrstation (8) relativ zu dem Werkstückträger (1) und/oder einer auf diesem angeordneten Leiterplatte (3, 3') positionierbar ist.

6. Werkzeugmaschine nach Anspruch 5, **dadurch gekennzeichnet, dass** die Deckschicht (4) im Wesentlichen bandförmig ist, wobei die zweite Einrichtung Rollen (9, 10) zum definierten Auf- und Abrollen der bandförmigen Deckschicht (4) aufweist.

7. Werkzeugmaschine nach Anspruch 5, **dadurch gekennzeichnet, dass** die Deckschicht (4) als eine relativ zu der Bohrstation (8) bewegbare Scheibe ausgebildet ist.

8. Werkzeugmaschine nach einem der vorhergehenden Ansprüche, **dadurch gekennzeichnet, dass** die Deckschicht (4) eine Platte oder Folie, insbesondere aus Aluminium oder Kunststoff, mit einer Dicke von etwa 0,1 mm bis etwa 1 mm, insbesondere etwa 0,2 mm bis etwa 0,5 mm, ist.

9. Werkzeugmaschine nach einem der vorhergehenden Ansprüche, **dadurch gekennzeichnet, dass** auf dem Werkstückträger (1) eine insbesondere mittels Saugern lösbar fixierte Unterlageschicht (2) in Form einer Platte derart vorgesehen ist, dass Leiterplatten (3, 3') auf der Unterlageschicht (2) poisitionierbar sind.

10. Werkzeugmaschine nach einem der vorhergehenden Ansprüche, **dadurch gekennzeichnet, dass** der Steuerung eine Erfassungseinrichtung zur Bestimmung der Position und/oder Ausrichtung einer Leiterplatte (3, 3') auf dem Werkstückträger (1) zugeordnet ist.

11. Verfahren zum Einbringen von Referenzbohrungen in Leiterplatten (3), insbesondere unter Verwendung einer Werkzeugmaschine nach einem der vorhergehenden Ansprüche, mit folgenden Schritten:
a) Auflegen einer zu bearbeitenden Leiterplatte (3, 3') auf eine definierte Position auf einer Unterlageschicht (2), die auf einem Werkstückträger (1) lösbar fixiert ist,
b) Auflegen und/oder Andrücken einer Deckschicht (4) auf zumindest einen Bereich der Leiterplatte (3, 3'),
c) Bearbeiten der Leiterplatte (3, 3') durch Einbringen wenigstens einer Bohrung in die Leiterplatte,
d) Abnehmen der Deckschicht (4) von der Leiterplatte (3, 3') und
e) Entfernen der bearbeiteten Leiterplatte (3, 3'),
f) Wiederholen der Schritte a) bis e) ohne Austausch der Unterlageschicht (2) und der Deckschicht (4),
wobei vor dem Schritt c) die Position und/oder die Ausrichtung der Leiterplatte (3, 3') erfasst wird, und wobei die Unterlageschicht (2), die zu bearbeitende Leiterplatte (3, 3') und die Deckschicht (4) vor Schritt d) so relativ zueinander ausgerichtet werden, dass die bei der aufeinanderfolgenden Bearbeitung mehrerer Leiterplatten (3, 3') in der Unterlageschicht (2) und in der Deckschicht (4) entstehenden Bohrlöcher in einem definierten Raster zueinander versetzt sind.

12. Verfahren nach Anspruch 11, **dadurch gekennzeichnet, dass** die Position und/oder die Ausrichtung der Leiterplatte (3, 3') vor dem Schritt b) mittels optischer Verfahren, insbesondere durch eine CCD-Kamera, erfasst wird.

13. Verfahren nach Anspruch 11, **dadurch gekennzeichnet, dass** die Position und/oder die Ausrichtung der Leiterplatte (3, 3') vor oder nach dem Schritt b) durch eine Röntgenaufnahme erfasst wird.

14. Verfahren nach einem der Ansprüche 11 bis 13, **dadurch gekennzeichnet, dass** der definierte Versatz der in der Unterlageschicht (2) und in der Deckschicht (4) entstehenden Bohrlöcher durch jeweils zueinander versetztes Auflegen der nacheinander zu bearbeitenden Leiterplatten (3, 3') und Einbringen der Bohrungen an zumindest im Wesentlichen gleichen Positionen auf den Leiterplatten (3, 3') erzeugt wird.

15. Verfahren nach einem der Ansprüche 11 bis 14, **dadurch gekennzeichnet, dass** die Unterlageschicht (2) und/oder die Deckschicht (4) nach Einbringen einer vorzugsweise voreinstellbaren Anzahl von Bohrlöchern ausgewechselt werden, wobei diese Anzahl ≥ 10 ist.
